Europäisches Patentamt

European Patent Office

Office européen des brevets

(19)

(11) Veröffentlichungsnummer: **0 313 996**
**A2**

(12) # EUROPÄISCHE PATENTANMELDUNG

(21) Anmeldenummer: **88117518.6**

(22) Anmeldetag: **21.10.88**

(51) Int. Cl.4: **H01L 39/12 , H01L 39/24**

(30) Priorität: **28.10.87 DE 3736523**

(43) Veröffentlichungstag der Anmeldung:
**03.05.89 Patentblatt 89/18**

(84) Benannte Vertragsstaaten:
**BE CH DE FR GB LI NL SE**

(71) Anmelder: **HOECHST AKTIENGESELLSCHAFT**
**Postfach 80 03 20**
**D-6230 Frankfurt am Main 80(DE)**

(72) Erfinder: **Rogalla, Horst Dr.,**
**Waalstrasse 223,**
**NL-7500 AE Enschede,(NL)**
Erfinder: **Häuser, Bernd,**
**Aulweg 13,**
**D-6300 Giessen,(DE)**

(54) **Dünner supraleitender Film, seine Herstellung und Verwendung.**

(57) Die Erfindung betrifft dünne supraleitende Filme aus keramischem Material mit Schicht stärken von 50 - 2000 nm mit epitaktischer Struktur. Das Material des Films enthält jeweils mindestens 1 Element der folgenden Gruppen (Nd - Gd, Dy - Lu, Y), (Ba, Sr), (Cu, Al, Fe, Ni, Pt, Ag, Zn), und (O, F, Cl, S). Die Filme werden hergestellt durch Absputtern von geeigneten Sintertargets bei Zimmertemperatur auf Substrate mit anschließender thermischer Nachbehandlung.

EP 0 313 996 A2

## Dünner supraleitender Film, seine Herstellung und Verwendung

Die Erfindung betrifft dünne supraleitende Filme, ihre Herstellung und Strukturierbarkeit durch Absputtern von geeigneten Sintertargets bei Zimmertemperatur auf Substrate mittels eines Sputterprozesses mit anschließender thermischer Nachbehandlung und ihre Verwendung.

Während bisher für alle konventionellen Supraleiter das relativ teure flüssige Helium als Kühlmittel eingesetzt werden mußte, arbeiten die neuen hochtemperatursupraleitenden Oxide auf der Basis YBaCuO bei Temperaturen, die bereits der Kühlung mit dem wesentlich billigeren flüssigen Stickstoff zugänglich sind. Die Herstellung und Charakterisierung der neuen Oxide als Bulk-Material wird inzwischen gut beherrscht. Für viele Anwendungen z. B. in der Kryo- und Mikroelektronik ist es jedoch notwendig, dieses Material in Form von dünnen Filmen auf ein geeignetes Substrat aufzubringen. Dies erweist sich jedoch bisher als relativ schwierig.

Das Sputtern von mehreren metallischen Targets (R. E. Somekh et al., Nature 326 (1987) 457; K. Char et al., preprint, 1987) hat ebenso wie das Elektronenstrahlverdampfen von mehreren Quellen (R. H. Hammond, Extended Abstracts for MRS Symposium on HTSC Anaheim, CA, April 1987; R. B. Laibowitz et al., preprint, 1987) den Nachteil, daß die Zusammensetzung insbesondere über größere Flächen nicht konstant gehalten werden kann. Die Zusammensetzung ist jedoch gerade ein Parameter, der für die supraleitenden Eigenschaften der Filme von wesentlicher Bedeutung ist.

Komplexe Verfahren wie die Molekularstrahlepitaxie (J. Kwo et al., "Proc. of the Berkeley Conf. on Novel Mechanisms in Superconductivity", 1987) oder gepulstes Laserverdampfen (D. Dijkkamp et al., preprint, 1987) sind zur Beschichtung größerer Flächen nicht geeignet und scheiden deshalb für einen technischen Einsatz ebenfalls aus. Beim RF-(Hochfrequenz)-Sputtern vom Keramiktargets weicht die Zusammensetzung des Targets bisher von derjenigen des erhaltenen Filmes ab. Außerdem sind die Übergänge in den Widerstands-Temperaturkurven so breit, daß diese Filme für einen Einsatz im Temperaturbereich des flüssigen Stickstoffs ungeeignet sind. (Hideaki Adachi et al., Jap. J. Appl. Phys. 26 (1987) L 709; Masashi Kawasaki Jap. J. Appl. Phys. 26 (1987) L 738; B. Häuser, H. Rogalla, Abstracts, European Workshop on HTSC Genua, Juli 1987).

Neben der Schichtherstellung selbst ist die Strukturierung dieser Schichten, d.h. die Formgebung, für bestimmte Anwendungen von entscheidender Bedeutung. Es ist bekannt, daß sowohl Trocken- als auch Naßätzprozesse die Charakteristik der Filme nachteilig verändern oder sogar deren Supraleitfähigkeit zerstören. Daher bietet sich als weitere Variante der Formgebung ein lithographischer Prozeß, die sog. Lift-off-Technik (J.H. Greiner et al., IBM J. Res. Develop. 24 (1980) L 195; L.D. Jackel in "SQUID 80", de Gruyter, Berlin 1980, L 257) an, bei der das Negativ der gewünschten Struktur, das sich auf einem Resistträger befindet, abgehoben und damit vom Positiv getrennt werden kann. Bei diesem Verfahren muß jedoch der Photoresist vor dem Sputterprozess auf das Substrat aufgebracht werden, so daß das Substrat aus diesem Grunde nicht zu stark erwärmt werden darf, um eine Zerstörung des Resists zu vermeiden. Im allgemeinen erfordern die bisher angewandten Verfahren zur Präparation epitaktischer supraleitender Schichten Substrattemperaturen von mehreren hundert Grad Celsius, so daß diese Verfahren für die "Lift-off"-Technik nicht eingesetzt werden können. Es bestand daher das Bedürfnis, auch für diese Technik ein geeignetes Verfahren zu finden.

Es war daher erwünscht, großflächige, homogene, supraleitende Filme ohne Beeinträchtigung der Eigenschaften des Materials zu erhalten, die die Nachteile der oben genannten Methoden nicht aufweisen.

Gegenstand der Erfindung ist ein dünner supraleitender Film aus keramischem Material mit einer kritischen Sprungtemperatur von oberhalb 77 K, der folgende Charakteristika besitzt: Schichtstärken im Bereich von 50 bis 2000 nm, epitaktische Struktur, aufgebaut ist aus den Elementen (Yttrium, Seltene Erden ohne Ce, Pr, Tb)-(Ba, Sr)-(Cu, Al, Fe, Ni, Pt, Ag, Zn)-(O, F, Cl, S), ein Verfahren zu seiner Herstellung sowie seine Verwendung. Darüberhinaus schließt die Erfindung auch ein Sintertarget ein, das zur Herstellung des Films eingesetzt wird und die in den Ansprüchen beschriebenen Kennzeichen hat.

Der Ausdruck "(Yttrium, Seltene Erden ohne Ce, Pr, Tb)-(Ba, Sr)-(Cu, Al, Fe, Ni, Pt, Ag, Zn)-(O, F, Cl, S)" bedeutet, daß jeweils mindestens ein Element aus den vier Gruppen (Y, La, Nd bis Gd, Dy bis Lu), (Ba, Sr), (Cu, Al, Fe, Ni, Pt, Ag, Zn, vorzugsweise Cu)-(O, F, Cl, S, vorzugsweise O) am Aufbau einer supraleitenden Phase im keramischen Material des Films beteiligt ist. Es ist vorteilhaft, wenn das eingesetzte keramische Material Perowskitstruktur aufweist.

Beispiele für bekannte supraleitende Materialien mit diesem Aufbau sind $Y_1Ba_2Cu_3O_{6,9}$ - (= supraleitendes "Y-Ba-Cu-O"), $GdBa_2Cu_3O_7$, und $La_{1,8}Ba_{0,2}CuO_4$. Der erfindungsgemäße Film ist meist auf einem Träger ( = Substrat) aufgebracht.

Das Verfahren wird in der Weise durchgeführt, daß keramische Materialteilchen eines Sintertargets in einer Gasatmosphäre auf ein Substrat gesputtert werden bei einer Temperatur von höchstens 60°C unter Anwendung eines Magnetfeldes mit Werten von mindestens 40 mT und die gebildete Schicht einer thermischen Nachbehandlung unterworfen wird.

Mit dem Verfahren is es möglich, sowohl im RF- als auch im DC(Gleichspannungs)-Betrieb, insbesondere auf MgO-Substraten, mittels eines Targets in passender Zusammensetzung epitaktische Schichten bei Zimmertemperatur herzustellen.

Als Sintertargets werden gepreßte keramische Materialien des Typs (Yttrium, Seltene Erden ohne Ce, Pr, Tb)-(Ba, Sr)-(Cu, Al, Fe, Ni, Pt, Ag, Zn)-(O, F, Cl, S), vorzugsweise die Standardsubstanz Y-Ba-Cu-O verwendet. Diese keramischen Materialien werden durch Sintern der Oxide hergestellt. Sie müssen noch nicht supraleitend sein. Das Mengenverhältnis der Metallatome soll jedoch so sein, daß nach Sintern und thermischer Nachbehandlung in Gegenwart von Sauerstoff eine supraleitende Phase gebildet wird.

Ein Y-Ba-Cu-O-Target kann also die supraleitende Zusammensetzung $YBa_2Cu_3O_{6,9}$ aufweisen. Es kann aber auch die breitere (i.a. nicht supraleitende) Bruttozusammensetzung $YBa_2Cu_3 O_x$ mit $x = 5$ bis 8 aufweisen. Aus dem gesinterten keramischen Material wird durch Pressen ein "Sintertarget" hergestellt.

Als Substrate kommen Isolatoren oder Halbleiter, z.B. $MgO$, $SrTiO_3$, $Al_2O_3$, $LiNbO_3$ oder $ZrO_2$ entweder einkristallin oder als gesputterte Zwischenschichten auf Trägermaterialien wie Silicium oder Quarz in Frage, deren Oberfläche unter RF-Bedingungen vorgereinigt wird.

Der Sputterprozess an sich ist bekannt. Hierbei können z.B. Magnetron-Sputteranlagen eingesetzt werden, die sowohl im RF- als auch im DC-Modus betrieben werden. Im DC-Modus erreicht man höhere Sputterraten bei gleichzeitig einfacherem Verfahren. Als Sputtergase können sämtliche Edelgase, vorzugsweise Argon, eventuell auch mit Sauerstoffbeimischung, mit einem Gasdruck unterhalb von 15, vorzugsweise 2-10 Pa verwendet werden. An der Targetoberfläche beträgt die Leistungsdichte 1 - 20 W/cm². Sowohl an der Targetoberfläche als auch im Sputterbereich beträgt das Magnetfeld mindestens 40 mT. Der Target-Substrat-Abstand kann im allgemeinen zwischen 3 und 10 cm variieren, bevorzugt wird der Bereich von 3 bis 6 cm.

Um die Aufheizung des Substrats durch Wärmeabstrahlung des Targets während des Sputterprozesses zu vermeiden, wird das Target im allgemeinen in schmale Streifen (die meist schmaler sind als 2 cm, insbesondere schmaler als 1 cm) geschnitten, auf einer kühlbaren Unterlage z.B. einer Metallplatte in dichter Packung befestigt, beispielsweise mit einem gut wärmeleitenden Kleber niedrigen Dampfdrucks, und auf Zimmertemperatur gekühlt. Diese Maßnahme dient gleichzeitig höhung der Rißbeständigkeit.

Trotz der erfindungsgemäßen Prozeßführung bei höchstens 60°C, vorzugsweise 20 bis 40 °C wird schon allein aufgrund der Einschußenergie der Sputterfragmente und deren Beweglichkeit ein homogenes epitaktisches Wachstum von Filmen auf dem Substrat ermöglicht, die eine Sprungtemperatur (Fußpunkt) im Bereich des flüssigen Stickstoffs, also oberhalb von 77 K, erzielen. Nach dem erfindungsgemäßen Verfahren können Schichten mit Stärken von 50 bis 2000, vorzugsweise 100 bis 1000 nm erzielt werden, deren Zusammensetzung auch über größere Flächen konstant d.h. homogen ist. Teilweise sind diese Schichten transparent.

Erst die thermische Nachbehandlung bei 500 - 1000, vorzugsweise 700 - 950 °C, in Sauerstoff-Atmosphäre und die darauffolgende langsame Abkühlung verwandeln die zunächst isolierende Schicht in einen Supraleiter. Die zunächst leicht texturierte, ungeordnete Schicht wird dabei in eine epitaktische Schicht umgewandelt. Die Abkühlung kann auch stufenweise mit dazwischenliegenden Verweilzeiten durchgeführt werden.

Ein weiterer Vorteil des erfindungsgemäßen Verfahrens ist die Möglichkeit, der aufgesputterten Schicht eine bestimmte Struktur, d.h. Form zu geben. Hierbei findet die schon erwähnte "Lift-off"-Technik Anwendung.

Im Gegensatz zu bekannten Verfahren zum Aufbringen dünner Schichten, die im allgemeinen Temperaturen oberhalb 400°C verlangen, liegt der Temperaturbereich des erfindungsgemäßen Verfahrens so günstig, daß ein Photoresist nicht beschädigt oder gar zerstört wird. Daher kann durch Beschichtung des Substrats mit einem Resist und einem nachfolgendem Lithographie-Schritt eine Vorstrukturierung des Films erreicht werden. Nach dem Sputterprozess läßt sich das Negativ dann von der positiven Mikrostruktur des Films abheben. Im Gegensatz zu Ätzverfahren, die auch die Seitenflächen der Struktur angreifen, wird durch die beschriebene Methode ein inhärenter, vollständiger Oberflächenschutz erzielt.

Zum Abheben des Negativs von dem aufgesputterten Film werden im allgemeinen Substanzen verwendet, die das Resistmaterial lösen oder zerstören, ohne die aufgebrachte Schicht zu beeinträchtigen. Beispielsweise finden organische Lösungsmittel Anwendung wie Aceton oder Isopropylalkohol.

Die erhaltenen erfindungsgemäßen Filme besitzen eine größere Homogenität und Lebensdauer, d.h. ihre physikalischen Charakteristika bleiben zeitlich stabil. Aufgrund dieser Eigenschaften finden sie Verwendung in der Kryo- und Mikro-Elektronik der supraleitenden Filme, insbesondere als Sensoren oder als Verbindungen auf Leiterplatten in Form von Leiterbahnen. Für diese Zwecke lassen sich Filme aus keramischen Supraleitern ebenso einsetzen wie die seit langem bekannten Filme aus metallischen Supraleitern mit wesentlich niedrigerer Sprungtemperatur.

**Beispiel**

Die Filme wurden in einer turbogepumpten Mehrkathodensputteranlage der Firma Balzers (Vaduz, Liechtenstein) im RF-Modus bei 27,12 MHz als auch durch DC-Magnetronsputtern aufgebracht.

Dazu wurde die Anlage zunächst auf einen Basisdruck von kleiner als $10^{-3}$ Pa evakuiert. Der Sputterprozeß selbst erfolgte in reinem Argon bei einem Druck von 8 Pa. Im RF-Modus betrug die Sputterrate bei einer PF-Leistung von 120 W etwa 1 Å/sec. Dabei stellte sich eine Targetgleichspannung von 70 - 80 V ein. Im DC-Modus konnte die Sputterrate bei 100 - 150 V und 400 - 600 mA auf 3 -4 Å/sec gesteigert werden.

Von einem gepreßten Target des YBaCuO-Typs mit 5 cm Durchmesser und 2 - 3 mm Dicke, das zur Kühlung und Rißvermeidung in Streifen geschnitten und auf eine Kupferplatte aufgeklebt war ("A-500 conductive cement" von Johnson Matthey Inc., Seabrook, NH, USA), wurde ein MgO-Einkristall-Substrat in (100)-Orientierung besputtert. Der Target-Substrat-Abstand betrug dabei 4 cm. Die Auftragsweise wurde an mehreren Substraten wiederholt, wobei Schichten mit einer Dicke von 400 bis 2000 nm erzielt wurden. Bis zu einer Stärke von 600 nm waren diese transparent.

In der folgenden thermischen Nachbehandlung wurde ein 400 nm dicker Film bei 920 °C eine Stunde lang einer Sauerstoffatmosphäre von 1 bar ausgesetzt. Nach einer Abkühlzeit von 7 Stunden mit einer Verweilphase von 30 Minuten bei 700 °C zeigte der Film einen scharfen resistiven Übergang in den supraleitenden Zustand oberhalb des Siedepunktes des flüssigen Stickstoffs bei 78 K.

Der Film wies unterhalb der Sprungtemperatur eine hohe kritischen Stromdichte von 1000 A/cm² (T = 25 K) auf, oberhalb eine gute metallische Leitfähigkeit von 1 mΩ•cm (T = 100 K). Weiterhin zeichnete er sich durch eine große Homogenität und Langzeitstabilität ohne Mikrorisse oder Verschlechterung der physikalischen Kenngrößen wie Sprungtemperatur und kritische Stromdichte aus.

**Ansprüche**

1. Dünner supraleitender Film aus keramischem Material mit einer kritischen Sprungtemperatur von oberhalb 77 K, dadurch gekennzeichnet, daß der Film folgende Charakteristika besitzt:
Schichtstärken im Bereich von 50 bis 2000 nm, epitaktische Struktur,
aufgebaut ist aus den Elementen (Yttrium, Seltene Erden ohne Ce, Pr, Tb)-(Ba,Sr)-(Cu,Al,Fe,Ni,Pt,Ag,Zn)-(O,F,Cl,S).

2. Verfahren zur Herstellung eines dünnen supraleitenden Films mit einer kritischen Sprungtemperatur von oberhalb 77 K dadurch gekennzeichnet, daß keramische Materialteilchen eines Sintertargets in einer Gasatmosphäre auf ein Substrat gesputtert werden bei einer Temperatur von höchstens 60 °C unter Anwendung eines Magnetfeldes mit Werten von mindestens 40 mT und die gebildete Schicht einer thermischen Nachbehandlung unterworfen wird.

3. Verfahren nach Anspruch 2, dadurch gekennzeichnet, daß ein Sintertarget eingesetzt wird, das aus gepreßten keramischen Materialien aus den Elementen (Yttrium, Seltene Erden ohne Ce,Pr,Tb)-(Ba,Sr)-(Cu,Al,Fe,Ni,Pt,Ag,Zn)-(O,F,Cl,S) besteht und in schmale Streifen geschnitten auf einer Unterlage befestigt ist.

4. Film nach Anspruch 1, dadurch gekennzeichnet, daß das keramische Material aus Y-Ba-Cu-O besteht.

5. Verfahren nach Anspruch 2, dadurch gekennzeichnet, daß als Substrat MgO, SrTiO₃, Al₂O₃, LiNbO₃ oder ZrO₂ eingesetzt wird.

6. Verfahren nach Anspruch 2, dadurch gekennzeichnet, daß das Substrat in einkristalliner Form oder als gesputterte Zwischenschicht auf einem Trägermaterial eingesetzt wird.

7. Verfahren nach Anspruch 2, dadurch gekennzeichnet, daß der Sputterprozess mit einer Leistungsdichte von 1 - 20 W/cm² betrieben wird.

8. Verfahren nach Anspruch 2, dadurch gekennzeichnet, daß der Sputterprozess mit einem Target-Substrat-Abstand von 3 - 10 cm durchgeführt wird.

9. Verfahren nach Anspruch 8, dadurch gekennzeichnet, daß der Abstand 3 bis 6 cm beträgt.

10. Verfahren nach Anspruch 2, dadurch gekennzeichnet, daß der Sputterprozess bei 20 bis 40 °C durchgeführt wird.

11. Verfahren nach Anspruch 2, dadurch gekennzeichnet, daß die thermische Nachbehandlung bei 500 - 1000 in Sauerstoffatmosphäre mit anschließender langsamer Abkühlung durchgeführt wird.

12. Verfahren nach Anspruch 11, dadurch gekennzeichnet, daß die Abkühlung stufenweise mit zwischenliegenden Verweilphasen durchgeführt wird.

13. Verfahren nach Anspruch 2, dadurch gekennzeichnet, daß vor dem Sputterprozess ein Photoresist auf das Substrat aufgebracht wird.

14. Sintertarget auf Basis gepreßter keramischer Materialien dadurch gekennzeichnet, daß die keramischen Materialien aus den Elementen (Yttrium, Seltene Erden ohne Ce,Pr,Tb)-(Ba,Sr)-(Cu,Al,Fe,Ni,Pt,Ag,Zn)-(O,F,Cl,S) bestehen, und in Form schmaler Streifen auf einer Unterlage befestigt sind.

15. Sintertarget nach Anspruch 14, dadurch gekennzeichnet, daß die Unterlage mit einer Kühlvorrichtung versehen ist.

16. Sintertarget nach Anspruch 14, dadurch gekennzeichnet, daß das keramische Material aus Y-Ba-Cu-O besteht.

17. Sintertarget nach Anspruch 14, dadurch gekennzeichnet, daß die Unterlage eine Metallplatte ist.

18. Verwendung des dünnen supraleitenden Films nach Anspruch 1 in der Kryo- und Mikro-Elektronik.

19. Verwendung nach Anspruch 18 als Sensoren oder als Verbindung auf Leiterplatten.

20. Verfahren nach Anspruch 3, dadurch gekennzeichnet, daß das keramische Material aus Y-Ba-Cu-O besteht.